# EUROPEAN PATENT SPECIFICATION

(11) **EP 1 949 390 B1**
(45) Date of publication and mention of the grant of the patent: **05.01.2011**
(21) Application number: 06807128.1
(22) Date of filing: 10.10.2006
(51) Int. Cl.: H01F 3/14

(54) **A POWER CONVERTER**
STROMWANDLER
CONVERTISSEUR DE PUISSANCE

(30) Priority: 10.10.2005 IE 20050684
(43) Date of publication of application: 30.07.2008
(73) Proprietor: Texas Instruments (Cork) Limited, Dublin 2 (IE)
(72) Inventor: YOUNG, George, County Dublin (IE); MEANEY, Peter Michael, County Cork (IE)
(74) Representative: Holt, Michael
(86) International application number: PCT/EP2006/067247
(87) International publication number: WO 2007/042519

(56) References cited:
- EP-A- 1 037 221
- FR-A1- 2 135 355
- US-A- 5 426 409
- US-A1- 2002 075 712
- US-A1- 2003 038 700
- US-A1- 2006 038 649
- US-B1- 6 377 315
- JIAN SUN ET AL: "Orthogonal winding structures and design for planar integrated magnetics" APPLIED POWER ELECTRONICS CONFERENCE AND EXPOSITION, 2004. APEC '04. NINETEENTH ANNUAL IEEE ANAHEIM, CA, USA 22-26 FEB. 2004, PISCATAWAY, NJ, USA,IEEE, 22 February 2004 (2004-02-22), pages 933-938, XP010705137 ISBN: 0-7803-8269-2
- BIELA J ET AL: "Electromagnetic integration of high power resonant circuits comprising high leakage inductance transformers" POWER ELECTRONICS SPECIALISTS CONFERENCE, 2004. PESC 04. 2004 IEEE 35TH ANNUAL AACHEN, GERMANY 20-25 JUNE 2004, PISCATAWAY, NJ, USA,IEEE, US, 20 June 2004 (2004-06-20), pages 4537-4545, XP010739130 ISBN: 0-7803-8399-0

## Description

### Introduction

This invention relates to a power converter comprising a plurality of sub-converters and a magnetic core, the plurality of sub-converters each having a primary winding and a secondary winding, the magnetic core further comprising an E-core having a first end leg, a centre leg and a second end leg, both the first and second end legs having a gap formed therein.

Power converters have been known for a long time and are used to transform an input voltage, which may be a mains supply voltage or other power supply voltage into an output voltage more suitable for a particular load to be driven by the power converter. Typically, power converters may be used to transform the input mains voltage into voltages suitable for use with integrated circuits and other electronic equipment. Other power converters are used to transform a DC intermediate drive voltage. Heretofore, there have been many different topologies used for effecting the power conversion. One particularly useful approach has been the usage of interleaved flyback converters with series connected primary windings. Another suitable approach other than the interleaved flyback converter approach is the current doubler approach. Both of these approaches are seen as effective and efficient for use with power converters.

One feature of both of these approaches, is that converters with such topologies can be implemented using two magnetic elements. These magnetic elements may be combined quite readily into a single E-core where there is a gap in each outer leg and the centre leg has no gap. In the implementation of such a converter, it is important that there is minimal leakage inductance between the primary and secondary windings. In order to achieve this, the windings are interleaved so that the primary and secondary windings physically overlap to the maximum extent possible. This typically requires that the primary and secondary windings associated with each stage are wound around the outer leg in the E-core implementation with winding interleaved using planar or foil winding techniques as appropriate particularly for low voltage high current implementations. For example the paper by JIAN SUN ET AL: "Orthogonal winding structures and design for planar integrated magnetics" APPLIED POWER ELECTRONICS CONFERENCE AND EXPOSITION, 2004. APEC '04. NINETEENTH ANNUAL IEEE ANAHEIM, CA, USA 22-26 FEB. 2004, PISCATAWAY, NJ, USA, IEEE, 22 February 2004 (2004-02-22), pages 933-938, there is described a current doubling arrangement of the type.

There have been provided various converters in which there is supplied a primary winding around each leg with the windings then connected in series with respect to each other. However there are numerous difficulties with such an implementation. Typically, this implementation requires additional interconnects between layers of a winding. These are usually implemented using via holes placed in the printed circuit board (PCB). However, placement of via holes is very difficult and it is important to maintain agency-mandated spacings between input and output connections in the converter. A partial solution involves the use of buried and/or blind vias. This however is undesirable due to the addition of extra processing steps in the manufacture of the PCB which further increases the cost of the PCB fabrication process.

Another problem with the known implementations of converter such as those described above, and in particular implementations with half-bridge primary excitation, is that these implementations are unbalanced in the context of generating common-mode electromagnetic interference (EMI). In a common mode noise management sense it is very desirable that a balanced condition exists so that the net common mode current flowing is minimised. One solution that has been suggested is to provide dummy noise-cancelling windings in either printed circuit board transformer implementations or in implementations using wound transformers. Although effective, this implementation takes up significant space within a transformer which is highly undesirable in the modern age of minimisation of electronic components in general. Having dummy windings whose sole purpose is for noise cancellation and which do not carry current can also add to leakage inductance in the converter. By providing additional dummy windings, the space provided for active current carrying windings is reduced thereby necessitating smaller active windings which are inherently more resistive which adds to the overall losses and reduces the efficiency of the converter.

### Statement of Invention

According to the invention there is provided a power converter as defined by the appended claims.

### Detailed Description of the Invention

The invention will now be more clearly understood from the following description of an embodiment thereof given by way of example only with reference to the accompanying drawings in which:-
Fig. 1 is a side cross-sectional view of a power converter E-core mounted on a printed circuit board;
Fig. 2 is a plan cross-sectional view of a primary winding for a converter according to the present invention;
Fig. 3 is a side cross-sectional view of an alternative embodiment of power converter with means to manage common-mode noise;
Fig. 4 is a diagrammatic representation of a ramp used for the control of pre-bias operation; and
Fig. 5 is a block diagram of a circuit used for generating the ramp voltage.

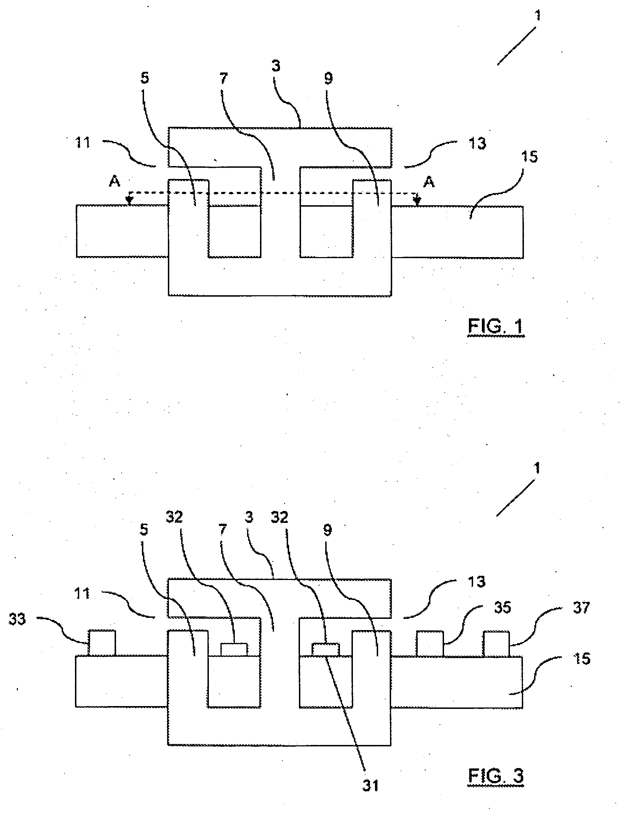

Referring to the drawings and initially to Fig. 1 thereof there is shown a power converter indicated generally by the reference numeral 1, comprising a plurality of sub-converters (not shown) and a magnetic core 3. The magnetic core 3 comprises an E-core having a first outer leg 5, an inner leg 7 and a second outer leg 9. Both the first and second outer legs 5, 9 have a gap 11, 13 respectively, formed therein. The magnetic core 3 is mounted on a printed circuit board (PCB) 15 having a plurality of layers (not shown).

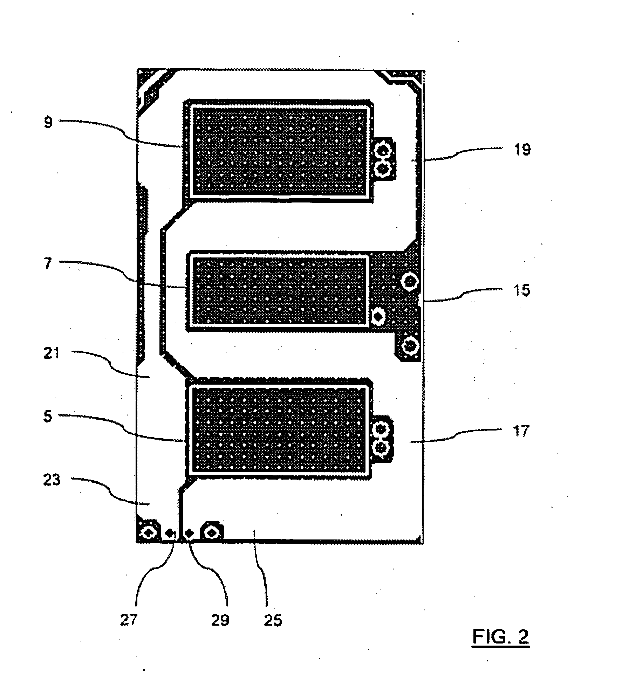

Referring to Fig. 2 of the drawings, where like parts have been given the same reference numeral as before, there is shown a plan cross-sectional view of the power converter taken along the lines "A-A" of Fig. 1. The power converter 1 comprises a plurality of sub-converters each having a primary winding 17, 19 and a secondary winding (not shown). The primary winding 17 of a first sub-converter is wound around the first outer leg 5 of the magnetic core 3 and a primary winding 19 of a second sub-converter is wound around the second outer leg 9 of the magnetic core. The pair of primary windings 17, 19 are formed from a unitary winding of conductive material 21. The unitary winding of conductive material 21 forming the pair of primary windings 17, 19, is led around the first outer leg 5 in a first orientation, in this case anti-clockwise, back between the first outer leg 5 and the inner leg 7, around the inner leg 7 in a second orientation (clockwise) opposite to the first orientation, back between the inner leg 7 and the second outer leg 9 and around the second outer leg 9 in the first orientation. Each end 23, 25 of the unitary winding of conductive material 21 terminates in a vias 27, 29 respectively. The vias 27, 29 are located in a corner 30 location of the PCB 15. Therefore, the unitary winding of conductive material 21 forms a single strip of conductive material that follows a labyrinthine route through the legs 5, 7, 9 of the power converter and substantially surrounds both of the outer legs 5, 9.

Referring to Figure 3 of the drawings, there is shown an alternative embodiment of power converter according to the present invention, where like parts have been given the same reference numerals as before. The power converter 1 further comprises means to manage common-mode noise, which comprises a dummy winding 31 having at least one turn 32 connected to a neutralising capacitive element 33. Preferably, the dummy winding 31 has a number of turns comparable to the number of turns of the primary winding of one of the sub-converters. The turns of the dummy winding 31 are placed around the inner leg 7 of the magnetic core 3. In addition to these components, a resistive element 35 and a capacitive element 37 are mounted on the PCB 15 and are provided for turning the cancellation properties and/or to limit ringing in the power converter. It will be understood that either or both of the resistive element 35 and the capacitive element 37 may be provided for this purpose. Furthermore, for reasons of clarity, only one turn 32 of the dummy winding 31 has been shown mounted on the surface of the PCB is and indeed this turn 32 has been shown exaggerated, protruding upwardly from the surface of the PCB 15 for reasons of clarity and it will be understood that when using planar techniques the turn will in fact be a relatively thin layer of conductive material on a layer of the PCB.

The dummy winding is connected in series with the cancellation capacitance which can be implemented as a discrete part as shown or by utilising the capacitance between copper planes in the PCB. The value of the capacitance can be trimmed or reduced by adding another series element. Alternatively, a resistor can be fitted in series to reduce any tendency for the dummy winding and PCB capacitance to ring at higher frequencies. All elements in the above common-mode noise management circuit may therefore be connected in series.

By having the dummy winding 31 wound around the centre leg 7 a very compact device may be provided that would be well balanced and efficient in use. Furthermore, the dummy winding 31 will not cause to reduce the size of the other windings 17, 19 that are current carrying windings. This is particularly useful as the efficiency of the power converter 1 is not affected adversely. In the embodiments shown the power converter 1 is shown using planar techniques but it will be understood that wire wound techniques could also be used for certain or all of the portions of the invention.

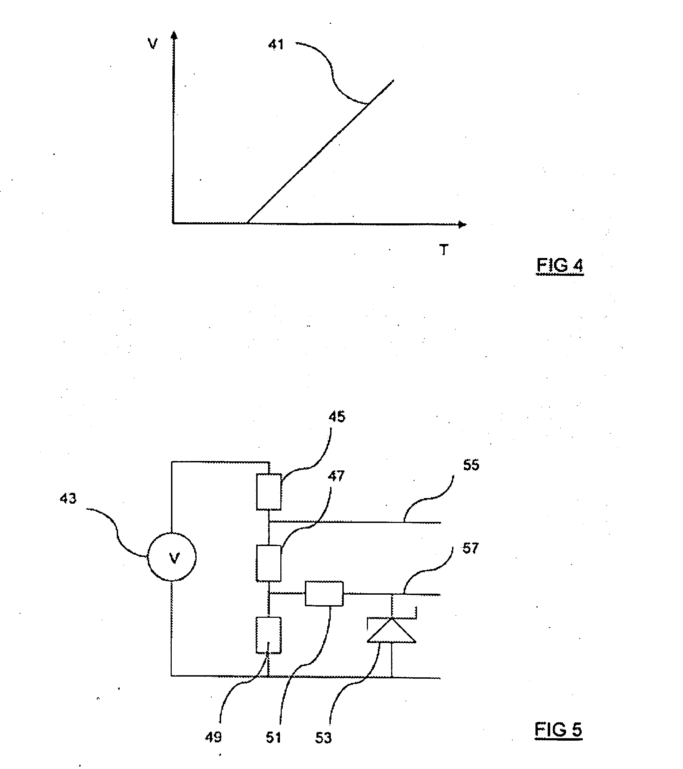

Referring to Fig. 4 of the drawings there is shown a ramp voltage 41 used for control of pre-bias operation in the power converter. The use of pre-bias control ensures that sinking current is not drawn from the output during start-up until the output is running at between 70 to 100% of the required output voltage. The ramp voltage 41 may be derived simply by charging a capacitor (not shown) to provide a suitable approximation of the desired ramp. The desired voltages for the gate drive and the output voltage setting may be derived from the ramp voltage 41.

Referring to Fig. 5 of the drawings there is shown a diagrammatic representation of the circuit schematic for control of the pre-bias operation in the power converter. A voltage source 43, which represents the ramp voltage created using a current source and a capacitor (both of which are not shown for clarity), is provided along with resistive components 45, 47, 49 and 51 as well as zener diode 53. From this circuit, the peak gate drive that is proportional to voltage on line 55, and the output proportional to voltage on line 57, may be obtained. Essentially, we wish to provide a relatively smooth ramp for control of the pre-bias operation as well as provide an inexpensive control circuit. The circuit shown will allow a smooth ramp to be produced at.a relatively low cost. Alternatively, it is envisaged that two ramp slopes (not shown), one of which allows for a soft transition of the gate drives of the synchronous rectifier elements (not shown) of the power converter from initially diode mode operation to synchronous rectifier operation could also be provided.

It will be understood that in the embodiments shown above, in addition to providing gaps in the E-core and a continuous inner leg 7, it will be understood that the gap may alternatively be implemented by abutting a separate section, such as a planar section, up against an extended inner leg 7. Furthermore, in the embodiments shown and described above, the power converter 1 has three legs in total including an inner leg 7 and a pair of outer legs 5, 9. It will be understood that this is a particular type of star configuration of a converter magnetic core 3 with two outer legs, which may also be referred to as poles, and an inner leg. Other star configurations with more than two outer legs (poles) could also be provided and indeed are intended to be covered within the scope of this specification and the appended claims. For example, a power converter with a magnetic core having an inner leg and three outer legs (poles), the three outer legs being evenly spaced from the inner leg and evenly spaced from each other symmetrically around the centre leg is also envisaged. In this embodiment, the three outer legs are separated by 120° with respect to each of the other outer legs around the inner leg. Furthermore, it is envisaged that there could be provided a power converter with an X-core, the X-core having an inner leg and four outer legs (poles) evenly spaced from each other symmetrically about the inner leg, separated 90° from adjacent outer legs, and so on and the example with two outer legs has been shown for convenience and illustrative purposes only.

Furthermore, although throughout the description, the windings on the outer legs have been described as separate sub-converters, it will be understood that typically, these sub-converters are not entirely separate and in fact are interleaved and in a normal embodiment the outputs of the sub-converters will be combined together for a single power converter output. The components have been described in this instance as sub-converters for reasons of convenience and clarity.

In this specification the terms "comprise", "comprises", "comprised" and "comprising" are deemed totally interchangeable and the terms "include", "includes", "included" and '"including" are deemed totally interchangeable and should be afforded the widest possible interpretation.

The invention is in no way limited to the embodiments hereinbefore described but may be varied in both construction and detail within the scope of the claims.

## Claims

1. A power converter (1) comprising a plurality of sub-converters and a magnetic core (3), the plurality of sub-converters each having a primary winding (17, 19) and a secondary winding, the magnetic core (3) further comprising an inner leg (7) and a plurality of outer legs (5, 9), each of the plurality of outer legs (5, 9) having a gap (11, 13) formed therein, arranged such that the primary windings (17, 19) of a plurality of the sub-converters each comprise a plurality of turns, each turn of one of the sub-converters being formed from a unitary winding of conductive material (21) with a corresponding turn of another sub-converter, each turn of the sub-converter being connected to another turn of that sub-converter by way of an interconnect, thereby connecting the primary windings of the sub-converters in series on a tum-by-tum basis and wherein the primary winding (17) of one of the sub-converters is wound around one of the outer legs (5) and the primary winding (19) of another sub-converter is wound around another of the outer legs (9), the primary windings (17, 19) being formed from a unitary winding of conductive material (21) which is wound around each of the outer legs and the inner leg (7), the unitary winding being wound at least partially around the inner leg between being wound around a pair of outer legs.

2. A power converter (1) as claimed in claim 1 in which the power converter further comprises a printed circuit board (PCB) (15) and the primary windings are constructed using planar techniques.

3. A power converter (1) as claimed in claim 2 in which each end (23, 25) of the unitary winding of conductive material (21) terminates in a vias (27, 29).

4. A power converter (1) as claimed in claim 3 in which the vias (27, 29) are located in a corner location of the PCB (15).

5. A power converter (1) as claimed in any preceding claim in which the magnetic core (3) further comprises an E-core having a first outer leg (5), an inner leg (7) and a second outer leg (9).

6. A power converter (1) as claimed in claim 5 in which the unitary winding of conductive material (21) is led around the first outer leg (5) in a first orientation, back between the first outer leg (5) and the inner leg (7), around the inner leg (7) in the opposite orientation to the first orientation, back between the inner leg (7) and the second outer leg (9) and around the second outer leg (9) in the first orientation.

7. A power converter (1) as claimed in claim 7 in which the unitary winding of conductive material (21) substantially surrounds each of the outer legs (5, 9).

8. A power converter (1) as claimed in any of claims 1 to 4 in which the magnetic core (3) further comprises a star configuration core in which there are provided three or more outer legs and an inner leg (7), the outer legs being evenly spaced from the inner leg and symmetrically spaced around the inner leg with respect to each other.

9. A power converter (1) as claimed in any preceding claim in which the power converter is further provided with means to manage common-mode noise, the means comprising a dummy winding (31) having at least one turn (32), the turn being connected to a neutralising capacitive element (33).

10. A power converter (1) as claimed in claim 9 in which the dummy winding (31) has a number of turns (32) comparable to the number of turns of the primary winding (17, 19) of a sub-converter of the power converter.

11. A power converter (1) as claimed in claim 9 or 10 in which the turn (32) of the dummy winding (31) is placed around the inner leg (7) of the magnetic core (3).

## Patentansprüche

1. Stromwandler (1), umfassend eine Mehrzahl von Wandleruntereinheiten und einen magnetischen Kern (3), wobei die Mehrzahl von Wandleruntereinheiten jeweils eine primäre Wicklung (17, 19) und eine sekundäre Wicklung aufweisen und der magnetische Kern (3) ferner einen inneren Schenkel (7) und eine Mehrzahl von äußeren Schenkeln (5, 9) aufweist, wobei jeder der äußeren Schenkel (5, 9) einen darin ausgebildeten Spalt (11, 13) aufweist,
so angeordnet, dass die primären Wicklungen (17, 19) der Mehrzahl von Wandleruntereinheiten jeweils eine Mehrzahl von Windungen umfassen, wobei jede Windung von einer der Wandlerunterheiten geformt ist aus einer einheitlichen Wicklung eines leitenden Materials (21) mit einer entsprechenden Windung einer anderen Wandleruntereinheit, wobei jede Windung der Wandleruntereinheit mit einer anderen Windung dieser Wandleruntereinheit durch eine Zwischenverbindung verbunden ist, wodurch die primären Wicklungen der Wandleruntereinheiten nach einem Windung-zu-Windung-Prinzip in Reihe verbunden sind, und
wobei die primäre Wicklung (17) einer der Wandleruntereinheiten um einen der äußeren Schenkel (5) gewickelt ist und die primäre Wicklung (19) einer anderen Wandleruntereinheit um einen der anderen äußeren Schenkel (9) gewickelt ist,
wobei die primären Wicklungen (17, 19) durch eine einheitliche Wicklung aus leitendem Material (21) gebildet ist, welche um jeden der äußeren Schenkel und um den inneren Schenkel (7) gewickelt ist, wobei die einheitliche Wicklung zwischen der Wicklung um ein Paar von äußeren Schenkeln wenigstens teilweise um den inneren Schenkel gewickelt wird.

2. Stromwandler (1) nach Anspruch 1, wobei der Stromwandler ferner eine Leiterplatte (PCB) (15) umfasst und die primären Wicklungen mittels planarer Techniken erstellt sind.

3. Stromwandler (1) nach Anspruch 2, wobei jedes Ende (23, 25) der einheitlichen Wicklung aus leitendem Material (21) in einem Durchgang (27, 29) endet.

4. Stromwandler (1) nach Anspruch 3, wobei die Durchgänge (27, 29) in einer Eckposition der PCB (15) angeordnet sind.

5. Stromwandler (1) nach einem der vorhergehenden Ansprüche, wobei der magnetische Kern (3) ferner einen E-Kern mit einem ersten äußeren Schenkel (5), einem inneren Schenkel (7) und einem zweiten äußeren Schenkel (9) umfasst.

6. Stromwandler (1) nach Anspruch 5, wobei die einheitliche Wicklung aus leitendem Material (21) in einer ersten Richtung um den ersten äußeren Schenkel (5), zurück zwischen dem ersten äußeren Schenkel (5) und dem inneren Schenkel (7), in einer zur ersten Richtung entgegengesetzten Richtung um den inneren Schenkel (7), zurück zwischen dem inneren Schenkel (7) und dem zweiten äußeren Schenkel (9) und in der ersten Richtung um den zweiten äußeren Schenkel (9) geführt wird.

7. Stromwandler (1) nach Anspruch 7, wobei die einheitliche Wicklung aus leitendem Material (21) im Wesentlichen jeden der äußeren Schenkel (5, 9) umgibt.

8. Stromwandler (1) nach einem der Ansprüche 1 bis 4, wobei der magnetische Kern (3) ferner einen sternförmigen Kern umfasst, welcher drei oder mehr äußere Schenkel und einen inneren Schenkel (7) aufweist, wobei die äußeren Schenkel gleichmäßig vom inneren Schenkel und zueinander symmetrisch um den inneren Schenkel beabstandet sind.

9. Stromwandler (1) nach einem der vorhergehenden Ansprüche, wobei der Stromwandler ferner mit einem Mittel zur Handhabung einer Gleichtaktstörung bereitgestellt ist, wobei das Mittel eine Blindwicklung (31) mit wenigstens einer Windung (32) umfasst, wobei die Windung mit einem neutralisierenden kapazitiven Element (33) verbunden ist.

10. Stromwandler (1) nach Anspruch 9, wobei die Blindwicklung (31) eine Anzahl von Windungen (32) aufweist, welche vergleichbar mit der Anzahl der Windungen der primären Wicklung (17, 19) einer Wandleruntereinheit des Stromwandlers ist.

11. Stromwandler (1) nach Anspruch 9 oder 10, wobei die Windung (32) der Blindwicklung (31) um den inneren Schenkel (7) des magnetischen Kerns (3) angeordnet ist.

## Revendications

1. Convertisseur de puissance (1) comprenant une pluralité de sous-convertisseurs et un noyau magnétique (3), la pluralité de sous-convertisseurs présentant chacun un enroulement primaire (17, 19) et un enroulement secondaire, le noyau magnétique (3) comprenant en outre une branche intérieure (7) et une pluralité de branches extérieures (5, 9), chacune de la pluralité de branches extérieures (5, 9) présentant un espace (11, 13) formé à l'intérieur, l'agencement étant tel que les enroulements primaires (17, 19) d'une pluralité de sous-convertisseurs comprennent chacun une pluralité de spires, chaque spire de l'un des sous-convertisseurs étant formée à partir d'un enroulement unitaire de matériau conducteur (21) avec une spire correspondante d'un autre sous-convertisseur, chaque spire du sous-convertisseur étant connectée à une autre spire de ce sous-convertisseur au moyen d'une interconnexion, en connectant de ce fait les enroulements primaires des sous-convertisseurs en série spire par spire, et dans lequel l'enroulement primaire (17) de l'un des sous-convertisseurs est enroulé autour de l'une des branches extérieures (5) et l'enroulement primaire (19) d'un autre sous-convertisseur est enroulé autour d'une autre des branches extérieures (9), les enroulements primaires (17, 19) étant formés à partir d'un enroulement unitaire de matériau conducteur (21) qui est enroulé autour de chacune des branches extérieures et de la branche intérieure (7), l'enroulement unitaire étant enroulé au moins en partie autour de la branche intérieure entre son enroulement autour d'une paire de branches extérieures.

2. Convertisseur de puissance (1) selon la revendication 1, dans lequel le convertisseur de puissance comprend en outre une carte de circuit imprimé (PCB) (15) et les enroulements primaires sont construits en faisant appel à des techniques planaires.

3. Convertisseur de puissance (1) selon la revendication 2, dans lequel chaque extrémité (23, 25) de l'enroulement unitaire de matériau conducteur (21) se termine dans un trou d'interconnexion (27, 29).

4. Convertisseur de puissance (1) selon la revendication 3, dans lequel les trous d'interconnexion (27, 29) se situent dans un coin de la carte de circuit imprimé (15).

5. Convertisseur de puissance (1) selon l'une quelconque des revendications précédentes, dans lequel le noyau magnétique (3) comprend en outre un noyau en E qui présente une première branche extérieure (5), une branche intérieure (7) et une seconde branche extérieure (9).

6. Convertisseur de puissance (1) selon la revendication 5, dans lequel l'enroulement unitaire de matériau conducteur (21) est amené autour de la première branche extérieure (5) selon une première orientation, à nouveau entre la première branche extérieure (5) et la branche intérieure (7), autour de la branche intérieure (7) selon une orientation opposée à la première orientation, à nouveau entre la branche intérieure (7) et la seconde branche extérieure (9) et autour de la seconde branche extérieure (9) selon la première orientation.

7. Convertisseur de puissance (1) selon la revendication 7, dans lequel l'enroulement unitaire de matériau conducteur (21) entoure sensiblement chacune des branches extérieures (5, 9).

8. Convertisseur de puissance (1) selon l'une quelconque des revendications 1 à 4, dans lequel le noyau magnétique (3) comprend en outre un noyau configuré en étoile dans laquelle sont disposées trois branches extérieures ou plus et une branche intérieure (7), les branches extérieures étant espacées de manière régulière à partir de la branche intérieure et étant espacées de manière symétrique entre elles autour de la branche intérieure.

9. Convertisseur de puissance (1) selon l'une quelconque des revendications précédentes, dans lequel le convertisseur de puissance est doté en outre de moyens servant à gérer le bruit de mode commun, les moyens comprenant un enroulement fictif (31) qui présente au moins une spire (32), la spire étant connectée à un élément capacitif de neutralisation (33).

10. Convertisseur de puissance (1) selon la revendication 9, dans lequel l'enroulement fictif (31) présente un certain nombre de spires (32) comparable au nombre de spires de l'enroulement primaire (17, 19) d'un sous-convertisseur du convertisseur de puissance.

11. Convertisseur de puissance (1) selon les revendications 9 ou 10, dans lequel la spire (32) de l'enroulement fictif (31) est placée autour de la branche intérieure (7) du noyau magnétique (3).
